# EUROPÄISCHE PATENTANMELDUNG

(11) **EP 1 898 467 A2**
(43) Veröffentlichungstag der Anmeldung: **12.03.2008**
(21) Anmeldenummer: 07017376.0
(22) Anmeldetag: 05.09.2007
(51) Int. Cl.: H01L 25/075, H01L 33/00

(54) **Halbleiter-Leuchtmittel und Leuchtenpaneel mit solchen**

(30) Priorität: 05.09.2006 DE 102006042061; 13.10.2006 DE 102006049081
(71) Anmelder: Noctron Holding S.A., 8140 Bridel (LU)
(72) Erfinder: Diamantidis, Georg, 56307 Dernbach (DE)
(74) Vertreter: Ostertag, Reinhard

(57) **Zusammenfassung**

Ein Halbleiter-Leuchtmittel umfaßt mindestens ein bei Spannungsbeaufschlagung leuchtendes Halbleiter-Leuchtelement (26, 28, 1016, 2016, 3016) und ein dieses tragendes Substrat (12, 1014, 2014, 3014). Das Substrat (12, 1014, 2014, 3014) ist für das von den Halbleiter-Leuchtelementen (26, 28, 1016, 2016, 3016) erzeugte Licht durchlässig.

## Beschreibung

Die Erfindung betrifft ein Halbleiter-Leuchtmittel gemäß dem Oberbegriff des Anspruches 1, sowie ein Leuchtpaneel mit solchen.

Halbleiter-Leuchtmittel sind in Form von Leuchtdioden-Leuchtmitteln bekannt, bei welchen die pn-Übergänge enthaltenden Halbleiter-Kristalle von lichtundurchlässigen Unterlagen getragen sind.

Halbleiter-Leuchtkristalle strahlen aus der Rekombination von Elektronen und Löchern stammendes Licht aber in allen Richtungen ab. Bei dem bekannten Halbleiter-Leuchtmitteln geht somit das in den hinteren Halbraum ausgestrahlte Licht zum großen Teil oder ganz verloren.

Durch die vorliegende Erfindung soll ein Halbleiter-Leuchtmittel gemäß dem Oberbegriff des Anspruchs 1 so weitergebildet werden, daß die Menge des Nutzlichtes vergrößert ist.

Diese Aufgabe ist erfindungsgemäß gelöst durch ein Halbleiter-Leuchtmittel mit den im Anspruch 1 angegebenen Merkmalen.

Bei dem erfindungsgemäßen Halbleiter-Leuchtmittel ist das das leuchtende Halbleiter-Leuchtelement tragende Substrat für das vom Halbleiter-Leuchtelement erzeugte Licht durchlässig. Nach hinten abgestrahltes Licht geht somit nicht verloren und kann verwendet werden, wobei ggfs. hinter dem Leuchtmittel angeordnete Spiegel dafür sorgen können, daß das Licht, welches nach hinten emittiert wird, ebenfalls in den vorderen Halbraum gelangt.

Vorteilhafte Weiterbildungen der Erfindung sind in Unteransprüchen angegeben.

Die im Anspruch 2 angegebenen Materialien für das das Halbleiter-Leuchtelement tragende Substrat sind nicht nur lichtdurchlässig sondern im Volumen klar, so daß das Substrat zu keiner Lichtstreuung führt.

Das im Anspruch 3 angegebene Substrat zeichnet sich durch besonders gute Härte und gute Lichtdurchlässigkeit in einem großen Wellenlängenbereich aus. Dieses Substrat ist auch chemisch besonders beständig und daher auch als Unterlage bei lithographischen Verfahren gut verwendbar.

Die im Anspruch 4 angegebenen Dickenverhältnisse für das Substrat sind im Hinblick auf geringes Gewicht und geringe Kosten des Substrates von Vorteil.

Verwendet man in dem Halbleiter-Leuchtelement als Lichtquellen Dreischicht-Strukturen, wie sie im Anspruch 5 angegeben ist, so wird die dem Leuchtelement zugeführte elektrische Energie mit besonders hohem Wirkungsgrad in Licht umgesetzt und das Spektrum läßt sich beeinflussen.

Auch die Weiterbildungen der Erfindung gemäß den Ansprüchen 6 bis 8 dienen einer hohen Lichtausbeute im Halbleiter-Leuchtelement.

Bei einem Leuchtmittel gemäß Anspruch 9 kann auch das im Inneren des Halbleiterelementes entstehende Licht Nutzzwecken zugeführt werden. Auch kann Licht durch hinter den Halbleiter-Leuchtelementen stehende Spiegel in den vorderen Halbraum reflektiert werden.

Die Weiterbildung der Erfindung gemäß Anspruch 10 erlaubt es, auch räumlich ausgedehnte Leuchtmittel zu realisieren, insbesondere auch flächige Leuchtmittel.

Die Weiterbildung der Erfindung gemäß Anspruch 11 ist im Hinblick auf eine hohe Leuchtdichte von Vorteil.

Dabei wird mit der Anordnung gemäß Anspruch 12 für den Fall, daß die Halbleiter-Leuchtelemente nur teilweise für Licht durchlässig sind oder lichtundurchlässig sind, eine hohe Leuchtdichte erhalten, wobei für beide Sätze von Halbleiter-Leuchtelementen das in Vorwärts- bzw. Rückwärtsrichtung abgegebene Licht genutzt wird. Daß die Halbleiter-Leuchtelemente der beiden Sätze auf verschiedenen Seiten des Substrates angeordnet sind, hat auch Vorteile im Hinblick auf eine gute wärmeabfuhr von den Halbleiter-Leuchtelementen.

Bei einem Leuchtelement gemäß Anspruch 13 ist das Substrat zusammen mit den von ihm getragenen Halbleiter-Leuchtelementen gegen mechanische Einwirkungen von außen weitgehend geschützt.

Dabei ist die Weiterbildung der Erfindung gemäß Anspruch 14 wieder im Hinblick auf die Realisierung flächiger Leuchtmittel von Vorteil.

Die Weiterbildung der Erfindung gemäß Anspruch 15 ist im Hinblick auf gute Kühlung der Halbleiter-Leuchtelemente von Vorteil.

Als lichtdurchlässige Kühlflüssigkeit hat sich dabei gemäß Anspruch 16 insbesondere Silikonöl bewährt. Dieses zeichnet sich auch durch große chemische Beständigkeit auch bei hohen Temperaturen aus.

Bei einem Leuchtmittel gemäß Anspruch 17 wirkt das Außengehäuse ggfs. zusammen mit einer zwischen Außengehäuse und dem die Halbleiter-Leuchtelemente getragenen Substrat eingefüllten Kühlmedium eine Linse, welche eine Bündelung des Lichtes bewerkstelligt.

Ein Leuchtmittel, wie es im Anspruch 18 angegeben ist, erzeugt weißes Licht, obwohl die Halbleiter-Leuchtelemente im UV oder im Blauen emittieren.

Die Ansprüche 19 und 20 geben bevorzugte Alternativen dafür an, die das Weißlicht erzeugenden Phosphorpartikel gleichförmig zu verteilen.

Die Weiterbildung der Erfindung gemäß Anspruch 21 hat den Vorteil, daß einer sehr dünnen flächigen pn-Schicht Strom verteilt zugeführt wird. Dies bedeutet, daß die Leuchtdichte des Halbleiter-Leuchtelementes vergleichmäßigt wird.

Auch die Weiterbildung der Erfindung gemäß Anspruch 22 ist im Hinblick auf große gleich stark leuchtende Bereiche des Halbleiter-Leuchtelementes von Vorteil.

Dieses Ziel wird mit einer Anordnung der Kontaktleiterbahnen, wie sie in Anspruch 23 angegeben ist, besonders gut erreicht.

Die Weiterbildung der Erfindung gemäß Anspruch 24 ermöglicht es, die Kontaktleiterbahnen selbst relativ dünn auszubilden. Derart dünne Kontaktleiterbahnen würden bei Einspeisung des Stromes nur an einer einzigen Stelle ebenfalls zu etwas ungleichförmiger Leuchtdichte des Halbleiter-Leuchtelementes führen, da die Kontaktleiterbahnen einen ins Gewicht fallenden Ohm'schen Widerstand haben. Bei einem Halbleiter-Leuchtelement gemäß Anspruch 24 erfolgt die Verteilung des Speisestromes über von den Kontaktleiterbahnen getrennte Speiseleiterbahnen des Basissubstrates, die mit größerer Dicke ausgeführt werden können und somit einen deutlich niedereren Ohm'schen Widerstand aufweisen.

Bei einem Leuchtmittel gemäß Anspruch 25 kann auch das zum Basissubstrat hin austretende Licht der Halbleiterelemente genutzt werden.

Das im Anspruch 26 angegebene Baissubstrat-Material zeichnet sich gute Härte und gute Lichtdurchlässigkeit in einem großen Wellenlängenbereich aus. Ein solches Basissubstrat ist auch chemisch gut beständig und daher auch als Unterlage bei lithographischen Verfahren gut verwenbar.

Die im Anspruch 27 angegebenen Dickenverhältnisse für das Basissubstrat sind im Hinblick auf geringes Gewicht einerseits und gute mechanische Stabilität andererseits von Vorteil.

Bei einem Leuchtmittel gemäß Anspruch 28 dient das Basissubstrat zugleich als Reflektor, der das in den Rückraum ausgesandte Licht zum Vorderraum hin zurückwirft.

Die Weiterbildung der Erfindung durch Anspruch 29 erlaubt es, die Basisleiterbahnen direkt ohne Zwischenschicht auf dem Basissubstrat anzubringen, welches zugleich einen Reflektor darstellt.

Die im Anspruch 30 genannten Materialien für das Basissubstrat sind im Hinblick auf Reinheit, chemische Beständigkeit und gute thermische Eigenschaften von Vorteil.

Für manche Anwendungsfälle ist es vorteilhaft, ein Standard-Leuchtmittel zu haben, welches Licht gleichermaßen nach vorne und hinten abstrahlt. Gemäß Anspruch 31 kann man ein derartiges Leuchtmittel so modifizieren, daß das insgesamt von dem Halbleiter-Leuchtelement ausgesandte Licht für vom Standardfall abweichende Anwendungen nach vorne abgestrahlt wird.

Die Weiterbildung der Erfindung gemäß Anspruch 32 ist im Hinblick auf guten Wirkungsgrad des Reflektorteiles von Vorteil.

Licht aussendende Halbleiter-Leuchtelemente sind mechanisch empfindliche Strukturen. Mit der Weiterbildung der Erfindung gemäß Anspruch 33 wird erreicht, daß das Leuchtmittel gut gegen Beschädigungen geschützt ist.

Die Weiterbildungen der Erfindung gemäß den Ansprüchen 34 bis 36 gestatten es, das Leuchtmittel mit einer hohen Betriebsspannung im Bereich von einigen 100 V bis zu einigen kV zu betreiben. Diese ist für manche Anwendungsfälle, wo das Vorliegen einer Hochspannung geprüft werden soll, von Vorteil. Bei einem Leuchtmittel gemäß einem der Ansprüche 34 bis 36 braucht man für derartige Einsatzzwecke keinen Spannungsteiler.

Dabei ist die Weiterbildung der Erfindung gemäß Anspruch 37 wieder im Hinblick auf ein Erzeugen von Weißlicht mit hohem Wirkungsgrad von Vorteil.

Ein Leuchtmittel, wie es im Anspruch 38 angegeben ist, kann direkt mit einer Hochspannungsquelle betrieben werden.

Durch die Weiterbildung gemäß Anspruch 39 ist die mechanische Stabilität des Leuchtelements verbessert.

Üblicherweise werden Halbleiter-Leuchtelemente aus einem EPI-Wafer, d.h. einem aus einem Halbleiter-Einkristall geschnittenen Wafer, gefertigt. Die Halbleiter-Leuchtelemente werden hierfür mittels an und für sich bekannter fotolithografischer und/oder Trockenätz-Verfahren aus dem EPI-Wafer aufgebaut. Das Trägersubstrat ist dabei häufig aus dem Wafermaterial selbst gebildet, welches wiederum das aufgebaute Halbleiter-Leuchtelement trägt. Der Wafer muß dann folglich ausreichend dick geschnitten sein, damit das fertiggestellte Halbleiter-Leuchtelement eine hinreichende mechanische Stabilität und Festigkeit aufweist. Der erreichbaren mechanischen Belastbarkeit sind jedoch bereits durch die Sprödheit des Wafers selbst Grenzen gesetzt. Darüber hinaus geht dasjenige Material des Wafers, welches beim fertigen Halbleiter-Leuchtelement als Trägersubstrat dient, für die Ausbildung von Halbleiter-Leuchtelementen verloren.

Das Halbleiter-Leuchtelement kann jedoch auch von einem Substrat aus einem anderen Material als demjenigen des Wafers getragen sein. Auch in diesem Fall wird die Stabilität des Leuchtelements durch das Substrat gewährleistet.

Die Ausbildung des Leuchtmittels gemäß Anspruch 39 bietet die Möglichkeit, daß, wenn das Substrat aus dem Wafer-Material gebildet ist, weniger Wafer-Material als Substrat verwendet werden muß. Das Substrat aus Wafer-Material kann also dünner als bei bekannten Halbleiter-Leuchtelementen ausgebildet sein. Dadurch wird Wafer-Material gespart und die Herstellungskosten werden insgesamt gesenkt. Die geforderte mechanische Stabilität und Belastbarkeit des Leuchtelements kann durch eine entsprechende Wahl des Materials für das Grundsubstrat erzielt werden.

Dabei ist eine Ausbildung gemäß Anspruch 40 vorteilhaft. Bei der Verwendung derartiger Gläser haben sich Glasmaterialien als günstig erwiesen, deren Zusammensetzung etwa einer der in Anspruch 41 angegebenen Zusammensetzung entspricht.

Derartige handelsübliche Glasmaterialien weisen gute mechanische Eigenschaften auf und sind zudem weitgehend unempfindlich gegen Temperaturschwankungen und sonstige äußere Einflüsse. Darüberhinaus sind sie über einen verhältnismäßig großen Wellenlängenbereich transparent.

Auch durch eine Ausbildung gemäß Anspruch 42 oder 43 sind die Herstellungskosten des Leuchtelements verringert, da weniger Wafer-Material als Substrat verwendet werden muss.

Die gewünschte Hauptabstrahlrichtung eines Leuchtmittels ist üblicherweise die dem Substrat entgegengesetzte Richtung, wobei ein Halbleiter-Leuchtelement normalerweise Licht in im wesentlichen alle Raumrichtungen emittiert. Um die Lichtausbeute des Lichtelements zu erhöhen, ist eine Ausbildung gemäß Anspruch 44 günstig. Strahlt nämlich das Halbleiter-Leuchtelement unter Spannungsbeaufschlagung Licht durch das transparente Grundsubstrat hindurch ab, so wird dieses Licht von der reflektierenden Schicht in Richtung auf die gewünschte Hauptabstrahlrichtung des Leuchtmittels reflektiert und trägt zusätzlich zur Lichtausbeute des Leuchtelements bei.

In der Praxis hat es sich als vorteilhaft erwiesen, wenn das Grundsubstrat eine Dicke gemäß Anspruch 45 hat. Bei diesen Dicken des Grundsubstrats wird eine gute mechanische Stabilität des Leuchtelements erreicht.

Bei einer Weiterentwicklung ist es im Hinblick auf das Substrat vorteilhaft, wenn dieses eine Dicke gemäß Anspruch 46 hat.

Anspruch 47 gibt ein Leuchtpaneel an, welches auch in sehr großen Abmessungen gefertigt werden kann, da die einzelnen Leuchtmittel gute mechanische Stabilität haben.

Ein Leuchtpaneel gemäß Anspruch 48 zeigt eine gute Wärmeabfuhr von den Leuchtmitteln und damit auch von den in diesen enthaltenen Halbleiter-Leuchtelementen.

Die Weiterbildungen der Erfindung gemäß den Ansprüchen 49 bis 51 sind im Hinblick auf die Bereitstellung von Weißlicht vorteilhaft.

Bei einem Leuchtpaneel gemäß Anspruch 52 wird das gesamte erzeugte Licht in den gleichen Halbraum abgegeben.

Die Weiterbildung der Erfindung gemäß Anspruch 53 ist im Hinblick auf gute Gleichförmigkeit der Helligkeit des Leuchtpaneeles von Vorteil.

Nachstehend wird die Erfindung anhand von Ausführungsbeispielen unter Bezugnahme auf die Zeichnung näher erläutert. In dieser zeigen:
- Figur 1: eine schematische Aufsicht auf eine Leuchtelement-Einheit, welche allein oder zusammen mit gleichen Einheiten in einem Gehäuse angeordnet ein Leuchtmittel bilden kann;
- Figur 2: eine Ansicht eines Halbleiter-Leuchtmittels, welches eine Vielzahl von Leuchtelement-Einheiten nach Figur 1 umfasst;
- Figur 3: eine Aufsicht auf ein weiteres Halbleiter-Leuchtmittel;
- Figur 4: einen Schnitt durch ein ausgedehntes, flächiges Halbleiter-Leuchtpaneel;
- Figur 5: eine vergrößerte Aufsicht auf eine Leuchtmittelkomponente;
- Figur 6: eine Aufsicht auf ein Leuchtmittel, welches man durch Aufbonden der Leuchtmittelkomponente von Figur 5 auf ein Basissubstrat erhält;
- Figur 7: eine schematische seitliche Darstellung eines von der Außengeometrie her diodenähnlichen Leuchtmittels;
- Figur 8: eine Aufsicht auf ein abgewandeltes Leuchtmittel, welches sechs Licht emittierende Halbleiter-Leuchtelemente aufweist;
- Figur 9: eine ähnliche Ansicht wie Figur 8, wobei jedoch das Leuchtmittel so abgewandelt ist, daß es weißes Licht abstrahlt und wahlweise auch mit einer Hochspannung betrieben werden kann;
- Figur 10: ein weiteres Ausführungsbeispiel eines Leuchtmittels, welches mehrere Halbleiter-Leuchtelemente umfaßt;
- Figur 11: eine Aufsicht auf einen vergrößerten Ausschnitt des Leuchtmittels von Figur 10, wobei ein Halbleiter-Leuchtelement vollständig zu erkennen ist;
- Figur 12: einen Schnitt durch den in Figur 11 gezeigten Ausschnitt des Leuchtmittels längs der dortigen Schnittlinie XII-XII;
- Figur 13: eine Abwandlung des Leuchtmittels nach Figur 10, wobei keine Verspiegelung vorgesehen ist; und
- Figur 14: einen Schnitt einer dem Leuchtmittel von Figur 5 entsprechenden abgewandelten Ausbildung des Leuchtmittels von Figur 10 ohne Grundsubstrat.

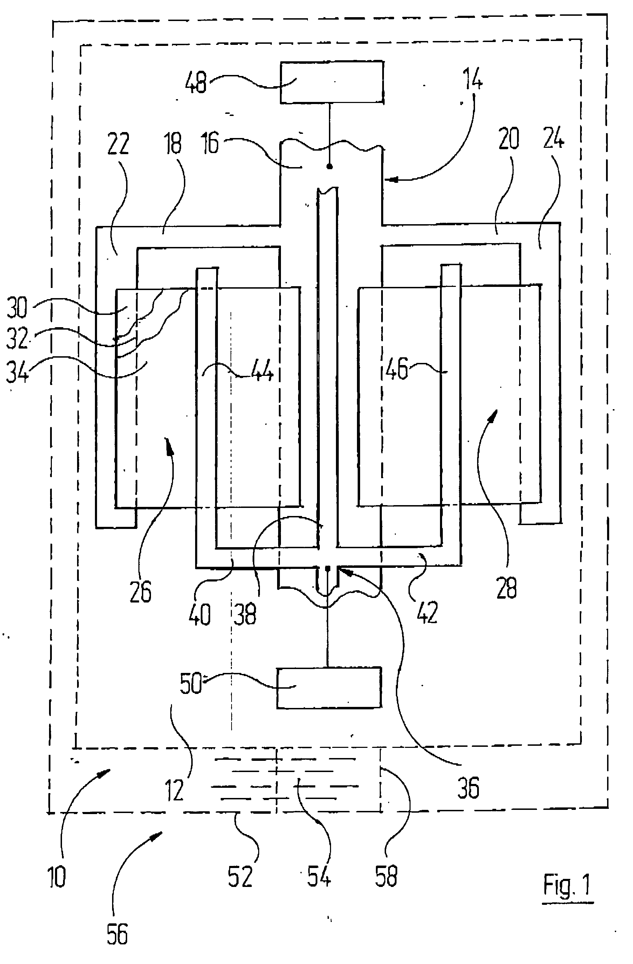

In Figur 1 ist mit 10 insgesamt eine Leuchtelement-Einheit bezeichnet, welche ein aus Korundglas (Al₂O₃-Glas) hergestelltes transparentes Substrat 12 umfasst. Derartige Gläser werden auch unter der Bezeichnung Saphirglas vertrieben. Sie zeichnen sich durch eine hohe mechanische Festigkeit, gute elektrische Isolationseigenschaften und gute thermische Eigenschaften aus. Das Substrat 12 hat in der Praxis eine Dicke von 300 bis 400 µm.

Auf der Oberseite des Substrates 12 ist eine insgesamt mit. 14 bezeichnete erste Elektrode angeordnet.

Diese umfasst eine mittlere Anschlußleiterbahn 16, die über transversale Arme 18, 20 parallel zur Anschlußleiterbahn 16 verlaufende Kontaktarme 22, 24 trägt.

Zwei flächige Leuchtelemente 26, 28 sind so über die Anschlußleiterbahn 16 und die Kontaktarme 22, 24 gelegt, daß sie letztere teilweise in transversaler Richtung überlappen, wie aus der Zeichnung ersichtlich.

Jedes der Leuchtelemente 26, 28 umfasst drei Schichten: Eine untere Schicht 30, welche die Anschlußleiterbahn 16 und die Kontaktarme 22, 24 kontaktiert und aus einem p-leitenden 111-V-Halbleiter-Material gefertigt ist, z. B. InGaN.

Eine mittlere Schicht 32 ist eine MQW-Schicht. MQW ist die Abkürzung für multiple quantum well. Ein MQW Material stellt ein Übergitter dar, welches eine gemäß der Übergitterstruktur veränderte elektronische Bandstruktur aufweist und entsprechend bei anderen Wellenlängen Licht emittiert. Über die Parameter der MQW-Schicht läßt sich das Spektrum des von den Leuchtelementen 26, 28 abgegebenen Lichtes beeinflussen.

Eine obere Schicht 34 ist eine n-leitende oder eigenleitende Schicht, die z. B. aus GaN bestehen kann.

Die drei Schichten haben insgesamt so geringe Dicke, daß die gesamte Dreischicht-Struktur für Licht durchlässig ist.

Auf die vorhergehend beschriebene Struktur ist eine zweite Elektrode 36 aufgedampft.

Diese hat eine Anschlußleiterbahn 38, die über eine dünne Oxidschicht auf die oben beschriebene Struktur gelegt ist und über transversale Arme 40, 42 Kontaktarme 44, 46 trägt, die in der Mitte über die oberen Schichten 34 der Leuchtelemente 26, 28 verlaufen.

Die Elektroden 14, 36 sind mit einer oberen Anschlußplatte 48 bzw. einer unteren Anschlußplatte 50 verbunden, die unter Betriebsbedingungen mit den Klemmen einer Spannungsquelle verbunden sind.

Auf diese Weise geben die Leuchtelemente 26, 28 bei Spannungsbeaufschlagung in Rückwärtsrichtung Licht ab, welches bei den o. g. Halbleitermaterialien im Bereich von 280 bis 360 nm und 360 bis 465 nm liegt.

Dieses Licht kann die Leuchtelement-Einheit 10 nach beiden Seiten hin verlassen, da das Substrat 12 und auch die Elektroden 14 und 36 transparent sind.

In der Praxis wird eine Leuchtelement-Einheit 10, wie sie oben beschrieben wurde, in ein transparentes Gehäuse 52 eingebaut, welches in Figur 1 nur gestrichelt dargestellt ist.

In den Zwischenraum zwischen dem Gehäuse 52 und die Leuchtelement-Einheit 10 ist Silikonöl 54 eingefüllt. Diese Flüssigkeit dient zur Wärmeabfuhr von der Leuchtelement-Einheit 10. Sie ist chemisch so inert, daß sie in direkten Kontakt zu den Materialien der Leuchtelement-Einheit 10 treten kann, ohne daß diese hierunter leiden. Silikonöl läßt sich auch sehr gut und bleibend entgasen und ist in den hier interessierenden Wellenlängenbereichen der elektromagnetischen Strahlung durchsichtig.

Zur mechanischen Anbindung des Substrates 12 an das Gehäuse 52 dient ein Glassockel 58.

Die Leuchtelement-Einheit 10 bildet zusammen mit dem Außengehäuse 52 und dem in dieses eingeschlossene Volumen an Silikonöl ein insgesamt mit 56 bezeichnetes Leuchtmittel.

Das Flüssigkeitsvolumen ist in der Zeichnung nur beispielhaft in einem Teilbereich des Geäuseinneren gezeigt. In Wirklichkeit füllt es das Gehäuseinnere vollständig aus. Dies gilt auch für die weiteren Figuren.

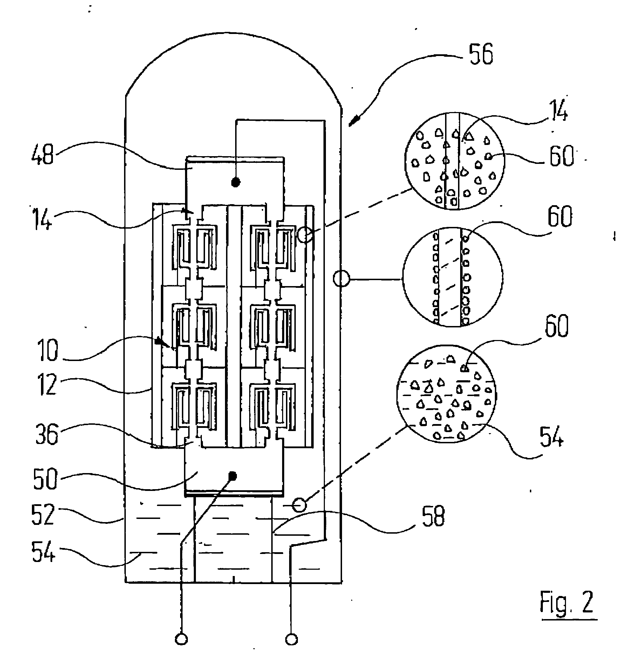

Zur Erhöhung der Lichtmenge des Leuchtmittels kann man eine Mehrzahl von Leuchtelement-Einheiten 10, wie sie obenstehend unter Bezugnahme auf Figur 1 erläutert wurden, auf einem gemeinsamen Substrat zusammenfassen. Ein entsprechendes Leuchtmittel 56 ist in Figur 2 dargestellt. Komponenten, die obenstehend unter Bezugnahme auf Figur.1 schon in funktionsäquivalenter Form erläutert wurden, sind wieder mit denselben Bezugszeichen versehen. Diese brauchen nachstehend nicht nochmals detailliert beschrieben zu werden.

Man erkennt, daß auf dem Substrat 12 sechs Leuchtelement-Einheiten angeordnet sind, von denen jeweils drei elektrisch in Reihe geschaltet sind. Die beiden Sätze aus drei in Reihe geschalteten Leuchtelement-Einheiten 10 sind in Parallelschaltung zwischen die Anschlußplatten 48, 50 geschaltet.

Wie oben dargelegt, strahlen die Leuchtelement-Einheiten 10 bei den genannten Halbleiter-Materialien im ultravioletten und im Blauen aus.

Um unter Verwendung dieser Leuchtelement-Einheiten eine Weißlichtquelle zu realisieren, sind in dem Silikonöl 54 Phosphorpartikel 60 verteilt, die aus einem Farbzentren aufweisenden transparenten Festkörpermaterial hergestellt sind.

Es finden drei Arten von Phosphorpartikeln Verwendung, die jeweils das von den Leuchtelement-Einheiten 10 ausgesandte UV-Licht und blaue Licht absorbieren und im Blauen, Gelben und Roten emittieren. Die Mengenverhältnisse zwischen den drei Phosphorpartikeln sind so gewählt, daß man unter Berücksichtigung eines ggfs. unterschiedlichen Wirkungsgrades der Lichtwelllen-Umsetzung für die verschiedenen Phosphorpartikel insgesamt vom Leuchtmittel 56 ein weißes Licht erhält.

Alternativ oder zusätzlich kann man vorsehen, daß die Innenfläche und/oder des Außengehäuses 52 mit Phosphorpartikeln 60 beschichtet ist. Dies kann z. B. dadurch erfolgen, daß man die entsprechende Seite des Außengehäuses 52 mit einem transparenten Lack überzieht und auf diesen in noch klebrigen Zustand die Phosphorpartikel-Mischung bläst. Dies ist in Figur 2 ebenfalls in einer Ausschnittsvergrößerung dargestellt.

Nochmals alternativ oder zusätzlich kann man eine derartige Partikelbeschichtung auch für die Leuchtelement-Einheit 10 vorsehen, wie ebenfalls in Figur 2 in einer Ausschnittsvergrößerung dargestellt.

Wir oben dargelegt, ist die gesamte Leuchtelement-Einheit 10 transparent (sowohl das Substrat 12 als auch die Elektroden 14, 36 als auch die Leuchtelemente 26, 28). Aus diesem Grunde ist vorzugsweise auf die Rückseite des Substrates 12 nochmals genau die gleiche Anordnung von Elektroden und Leuchtelemente aufgebracht. Man erhält so bei gleichem Volumen des Leuchtmittels 56 die doppelte Lichtmenge.

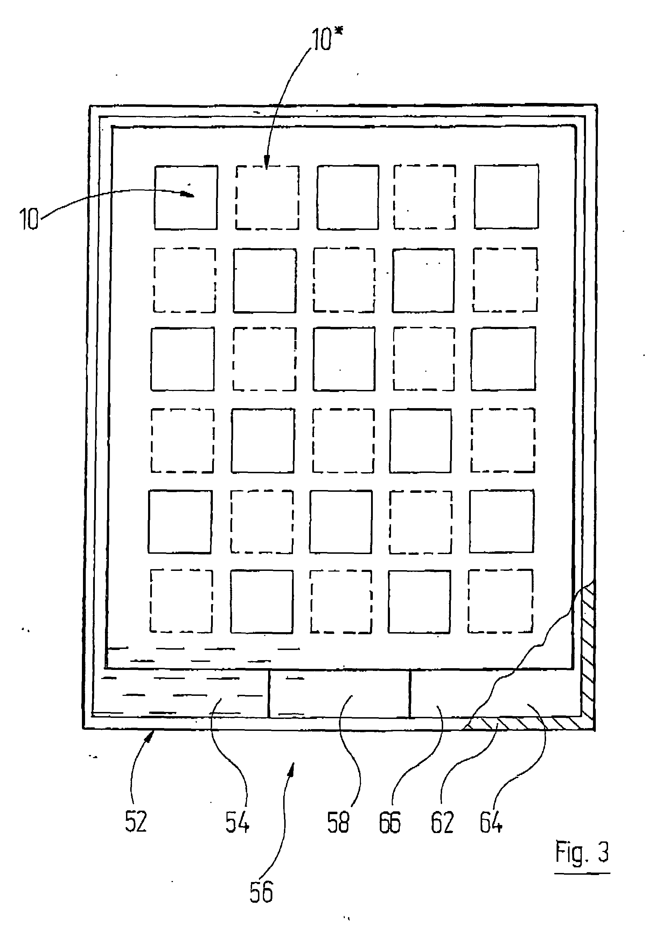

Figur 3 zeigt ein nochmals ausgedehnteres flächiges Leuchtmittel 56, wie es zur Hinterleuchtung von Displays verwendet werden kann. Man erkennt die in einer Matrix angeordneten Leuchtelement-Einheiten 10, wobei nun die auf den beiden Seiten des Substrates 12 angeordneten Leuchtelement-Einheiten gegeneinander versetzt sind. Eine derartige Anordnung wird gewählt, wenn die Leuchtelement-Einheiten 10 selbst nicht lichtdurchlässig sind.

Das Außengehäuse 52 besteht nun aus einem äußeren Rahmen 62 und Deckplatten 64, 66. Diese haben eine nach Art von Mattglas aufgerauhte Innenfläche, um den Lichtstrom zu vergleichmäßigen.

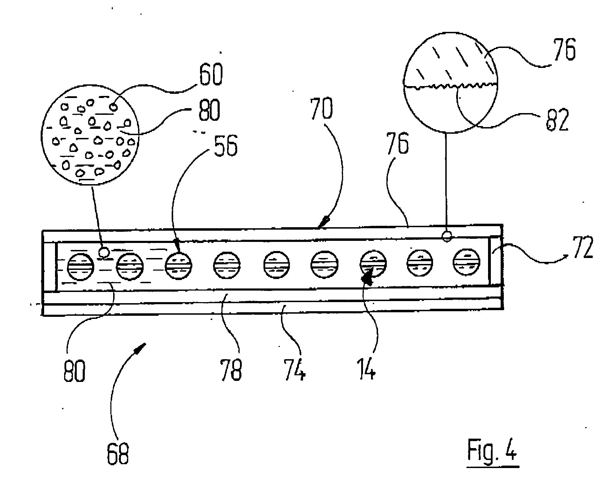

Das Ausführungsbeispiel nach Figur 4 zeigt ein Halbleiter-Leuchtpaneel 68. Im Inneren eines ähnlich wie in Figur 3 ausgebildeten Paneelgehäuses 70 einzelne zylindrische Leuchtmittel 56 angeordnet, wie sie in Figur 2 gezeigt sind, wobei jedoch die Anzahl der in Serie geschalteten Leuchtelement-Einheiten 10 eines Leuchtmittels größer sein kann, z. B. 10 oder 20 Einheiten.

Das Paneelgehäuse 70 hat einen Rahmen 72 und Deckplatten 74, 76, die sämtlich transparent sind. Dabei trägt die untere Deckplatte 74 eine Spiegelschicht 78, so daß das gesamte von den Leuchtmitteln 56 erzeugte Licht nach einer Seite hin abgegeben wird.

Der zwischen den einzelnen Leuchtmitteln 56 und dem Paneelgehäuse 70 liegende Raum ist wieder mit Silikonöl 80 gefüllt, um die Wärmeabführung zur Umgebung zu begünstigen. In diesem sind wieder Phosphorpartikel 60 verteilt, wie oben beschrieben.

Ein mattierte untere Begrenzungsfläche 82 der Deckplatte 76 sorgt für eine gleichförmige Leuchtdichte des Leuchtpaneeles.

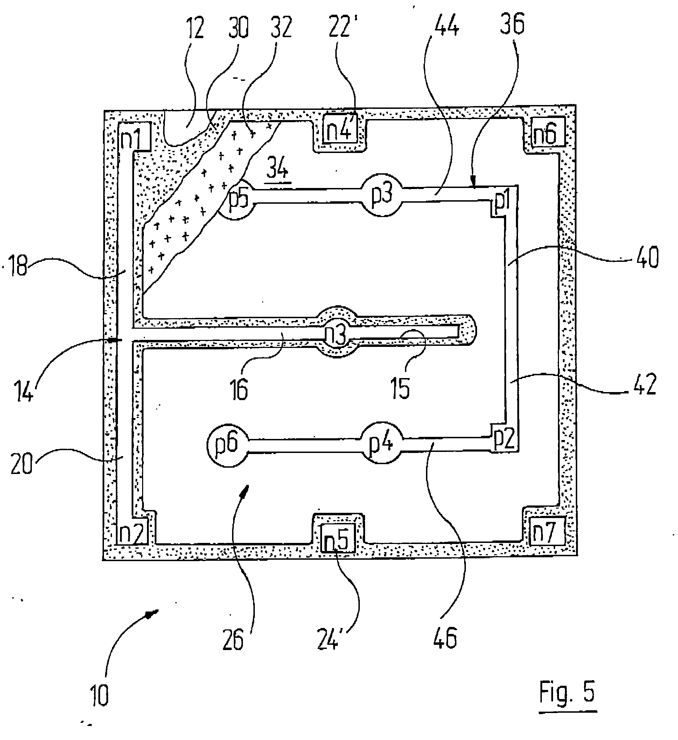

Das Ausführungsbeispiel nach Figur 5 ähnelt demjenigen nach Figur 1. Die Kontaktarme 22, 24 und 44, 46 sind nun aber nicht direkt mit Strom zuführenden Leiterbahnen verbunden, wie sie in Figur 1 bei 16 und 38 gezeigt sind, vielmehr sind auf ihre Länge verteilt sieben Anschlußpolster n1 bis n7 vorgesehen. Entsprechend tragen die Kontaktarme 44, 46 Anschlußpolster p1 bis p6.

Auf die Anschlußpolster ni (i=1 bis 7) und/oder pi (i=1 bis 6) ist jeweils ein kleines volumen Lot aufgebracht (nicht dargestellt), welches bei etwa 350° C schmilzt.

Die Kontaktarme stehen in Verbindung mit der Unterseite bzw. Oberseite eines einzigen flächigen Leuchtelements 26, das wieder aus den drei Schichten 30, 32 und 34 besteht.

Um die Schicht 30 von derselben Seite her kontaktieren zu können wie die Schicht 34 und auch zum mitteleren Bereich der Schicht 30 Zugang zu haben, weist die Schicht 34 eine mittlere schlitzförmige Ausnehmung 15 auf, in welcher der Leiterbahnabschnitt 16 unter seitlichem Abstand Aufnahme findet.

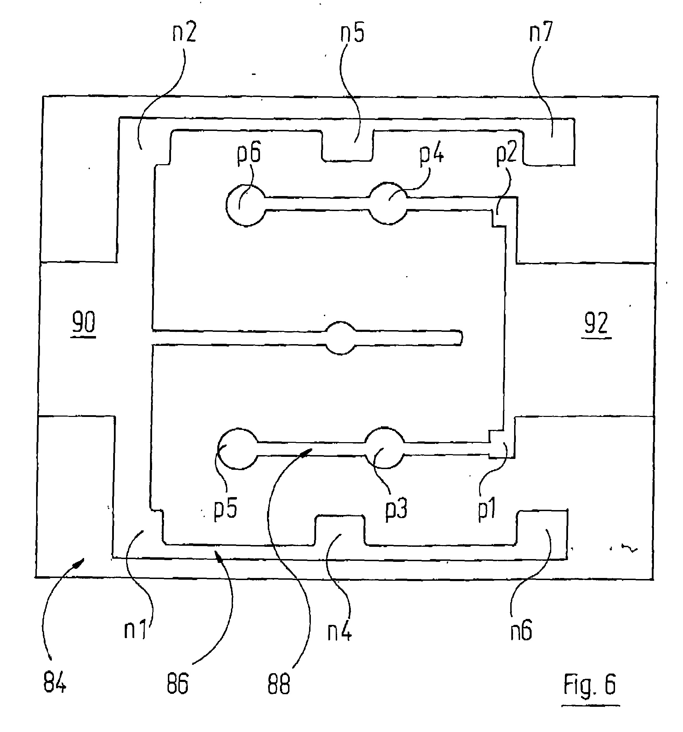

Figur 6 zeigt eine Aufsicht auf eine untere Basisplatte 84, auf welche die Leuchelement-Einheit 10 von Figur 5 so auflötbar ist, daß die in figur 5 obere Seite nach unten weist und die Oberseite der Basisplatte 84 kontaktiert.

Die Basisplatte 84 hat eine positive Speiseleiterbahn 86 und eine negative Speiseleiterbahn 88. Diese haben im wesentlchen die gleiche Geometrie wie die Elektroden 14 und 36 und sind ebenfalls mit Anschlußpolstern n1 bis n7 und p1 bis p6 versehen, derart, daß beim Auflöten der in Figur 5 gezeigten Leuchtmitteleinheit auf die Basisplatte 84 die Elektroden 16, 36 an mehreren beabstandeten Stellen mit den Speiseleiterbahnen 86, 88 verbunden werden.

Die Speiseleiterbahnen 86, 88 können wesentlich dicker auf die Basisplatte 84 aufgebracht sein (in der Praxis 4 bis 10 mal so dick) und damit einen wesentlich niedereren Widerstand haben als die sehr dünnen Elektroden 14, 36, deren Dicke in der Praxis 10µm bis 40 µm beträgt.

Die Elektroden 14, 36 und die Speiseleiterbahnen 86, 88 sind durch Aufdampfen eine Kupfer-Gold-Legierung erhalten. Alternativ können auch Silber- oder Aluminium-Legierungen verwendet werden.

Die Speiseleiterbahnen 86, 88 sind mit großen Kontakten 90, 92 verbunden, über welche der Anschluß an die Spannungsqelle erfolgt.

Bei einem praktischen Ausführungsbeispiel des in den Figuren 5 und 6 gezeigten Leuchtmittels besteht die Schicht 30 der Leuchtelemente 26 aus InGaN und die Schicht 34 aus GaN. Die Mittelschicht 32 ist wieder eine MQW-Schicht (multiple quantum well-Schicht), die ein Übergitter bildet, über welches man die Wellenlänge des emittierten Lichtes beeinflussen kann.

Die Substratplatte 12 hat bei dem praktischen Ausführungsbeispiel eine Kantenabmessung von etwa 1 mm bei einer Dicke von etwa 0,15 mm. Die Basisplatte 84 hat Kantenlängen von etwa 1,9 mm und 1,5 mm und eine Plattendicke von etwa 0,4 mm. Beide Platten sind aus Saphir geschnitten.

Die Anschlußpolster sind in üblicher Weise aus Gold hergestellt, welches für den Anschluß an eine p-leitende Schicht bzw. eine n-leitende Schicht dotiert ist.

Die obenstehend unter Bezugnahme auf die Figuren 5 und 6 beschriebene Konstruktion erlaubt eine im wesentlichen durchgehend transparente Lichtquelle mit gleichförmiger Leuchtdichte.

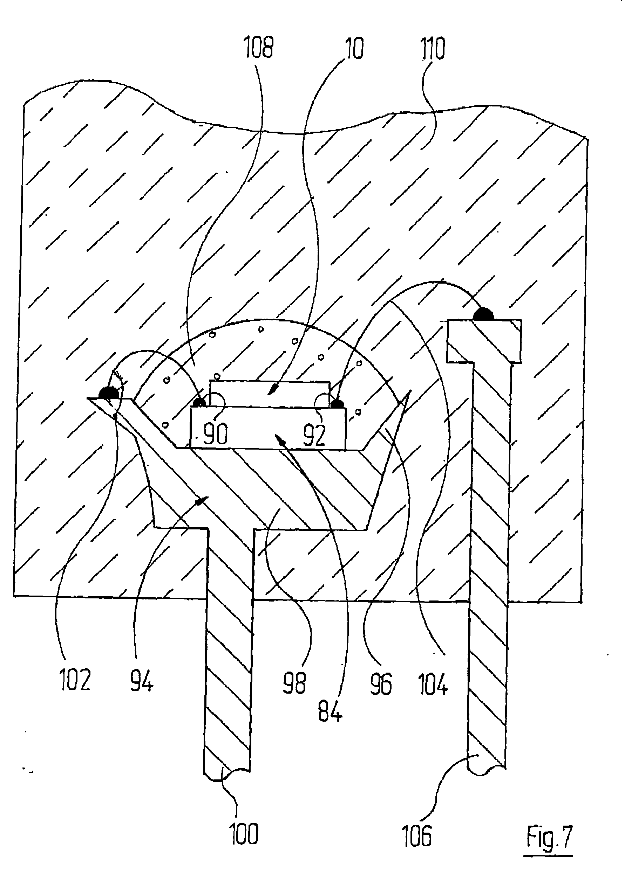

Gemäß Figur 7 ist die Leuchtelementeeinheit 10, von welcher die Substratplatte 12 und die Basisplatte 84 nur schematisch angedeutet sind, im Inneren eines schüsselförmigen Reflektors 94 angeordnet. Dieser hat eine nach oben spitz zulaufende kegelige Umfangswand 96, eine Bodenwand 98 und einen Kontaktstift 100.

Über einen Draht 102 ist die Leuchtelementeeinheit elektrisch mit dem Reflektor 94 verbunden.

Ein weiterer Draht 104 verbindet die zweite Anschlußklemme der Leuchtelementeeinheit mit einem weiteren Kontaktstift 106, der parallel unter Abstand zum Kontaktstift 100 angeordnet ist.

Die Leuchtelementeeinheit 10 ist mit einem Konversionsmaterial 108 überschichtet, welches ein Silikon/Phosphor-Gemisch ist. Dabei ist das Phosphor-Material wieder eine Mischung unterschiedlicher Phosphor-Materialien, die das von der Leuchtelementeeinheit 10 emittierte Licht absorbieren und im Blauen, Gelben und Roten emittieren, wie weiter oben beschrieben.

Die gesamte oben beschriebene Einheit ist in ein Volumen aus transparentem Epoxidharz 110 eingebettet, welches eine zylindrische Grundgeometrie bei ggfs. kalottenförmiger Endfläche aufweist, wie an sich von Leuchtelemente her bekannt.

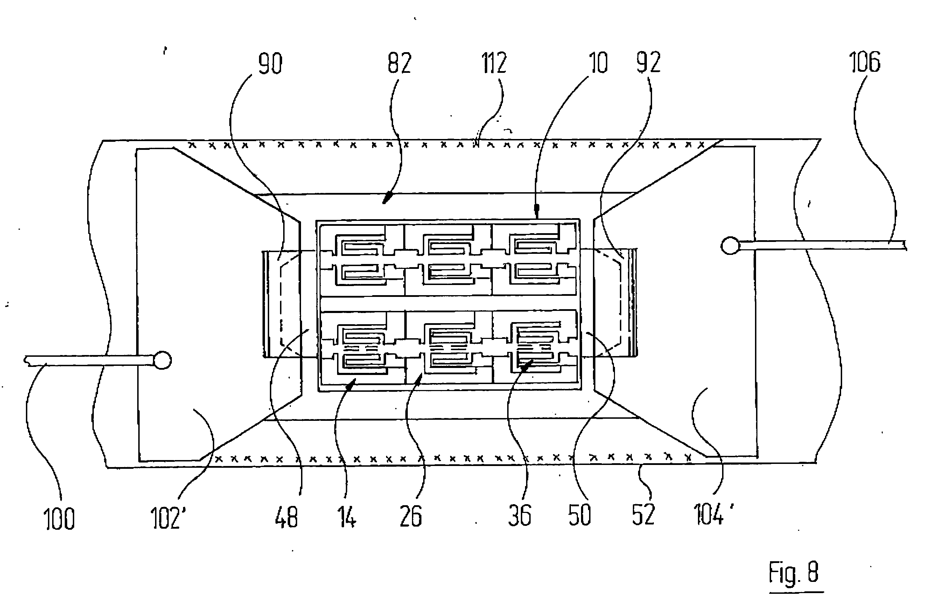

Figur 8 zeigt ein Leuchtmittel, welches ähnlich ist zu demjenigen nach Figur 2. Vergleichbare Teile sind wieder mit demselben Bezugszeichen versehen.

Ein Unterschied zum Leuchtmittel nach Figur 2 besteht darin, daß bei dem Leuchtmittel nach Figur 8 zwei Leuchtelement-Einheiten 10 Rücken an Rücken in das Gehäuse 52 eingebaut sind.

Außerdem ist vorgesehen, daß die Innenfläche des Gehäuses 52 zusätzlich eine Phosphorschicht 112 trägt, die wieder ein Gemisch aus Phosphorpartikeln darstellt, die das von den Leuchtelemente abgegebene Licht absorbieren und im Blauen, Gelben und Roten emittieren.

Großzüzgig bemessene Anschlußplatten 102' und 104' sind aus Metall hergestellt und dienen auch dazu, Wärme von den Leuchtelemente abzuführen.

Das Gehäuse 52 ist ein Glaszylinder 52, der unter einem Vakuum von etwa 2 x 10⁻2 bis 5 x 10⁻4 Torr steht.

Auf die Innenseite der Glaswand des Gehäuses 52 ist. eine gitterförmige Elektrode 114 aus Graphit aufgebracht. Die Graphit-Elektrode 114 steht mit einem Anschluß 116 in Verbindung, der von einer Hochspannungsquelle 118 her mit Spannung beaufschlagt werden kann. Diese kann im Bereich von 220 V bis 10 kV liegen.

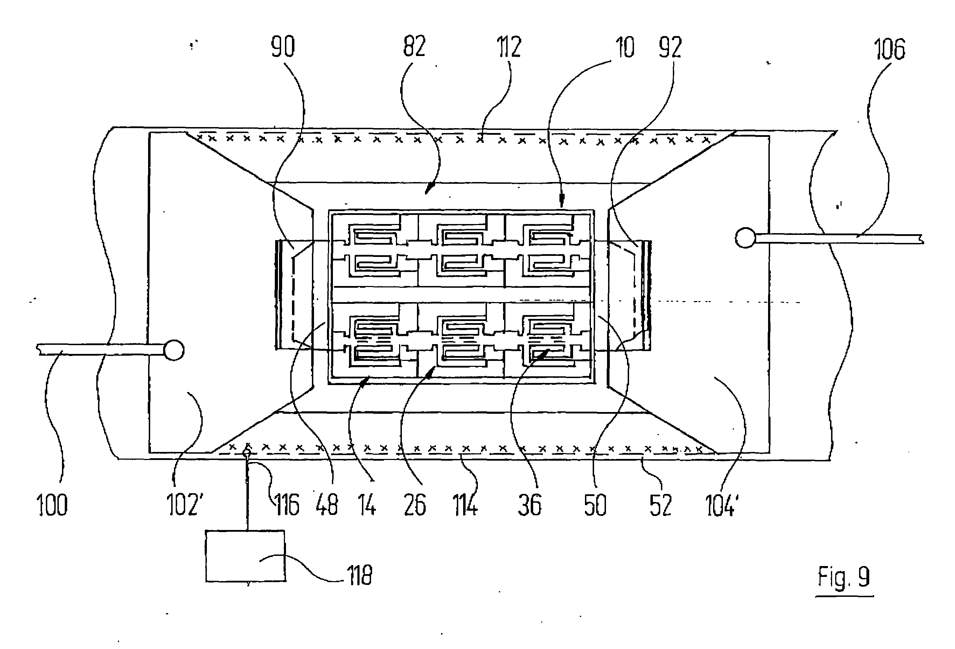

Das in Figur 9 gezeugte Leuchtmittel kann wahlweise mit Niederspannung betrieben werden (Anlegen einer Spannung von etwa 7,5 bis.etwa 11 V an die Anschlußplatten 48, 50) oder mit Hochspannung betrieben werden (Anlegen von Hochspannung an den Anschluß 116 und Anschluß von Masse an die Anschlußplatte 50).

Zur Herstellung von Weißlicht kann die Elektrode 114 tragende Innenfläche des Gehäuses 52 wieder mit einer Phosphorschicht 112 belegt sein, wie weiter oben beschrieben. Dabei kann die Phosphorschicht 112 zugleich die Gittermaschen der Elektrode 114 ausfüllen.

Bei den unter Bezugnahme auf die Figuren 5 bis 9 erläuterten Ausführungsbeispielen erfolgt das Herstellen des Leuchtmittels in drei Teilschritten: Das Herstellen der Leuchtelement-Einheit 10 auf dem Saphir-Substrat 12, das Herstellen der Saphir-Basisplatte 84 und der von dieser getragenen Speiseleiterbahnen 86, 88 und das Verbinden von Leuchtelement-Einheit 10 und Basisplatte 84.

Auf die Anschlußpolster n1 bis n7 und p1 bis p6 von Substratplatte 12 und/oder Basisplatte 84 wurden bei deren Herstellung kleine Lötmaterialtröpfchen aufgebracht, die dann gemeinsam in einem heißen Verfahren bei etwa 350°C unter Einwirkung von Druck aufgeschmolzen werden. Nach dem Erkalten des Lotes sind Leuchtelementeeinheit 10 und Basisplatte 84 zugleich mechanisch und elektrisch verbunden.

Die gesamten Herstellungschritte für die Leuchtmittel lassen sich somit einfach unter Verwendung der bekannten Halbleiter-Herstellungsverfahren durchführen.

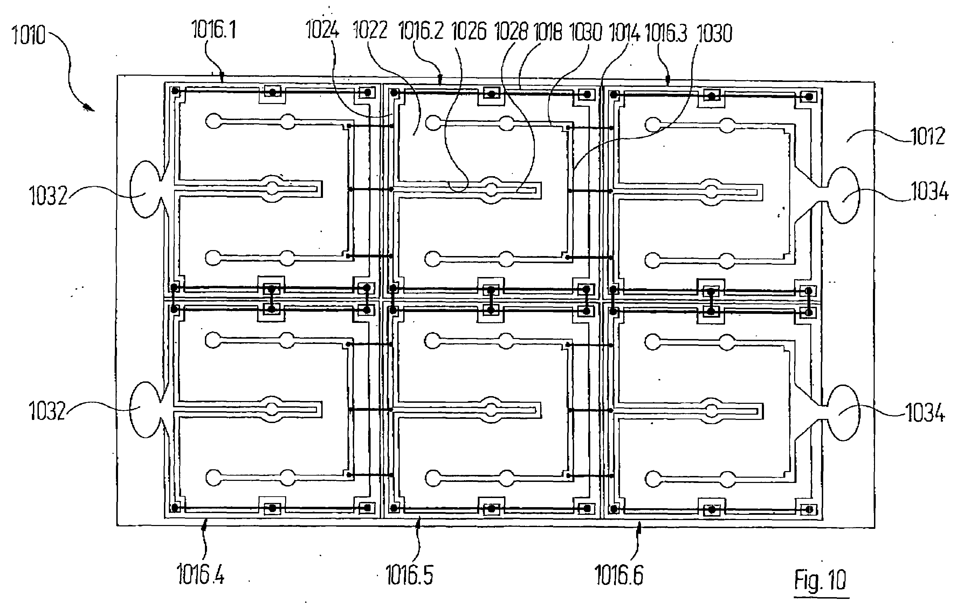

In Figur 10 ist bei einem weiteren Ausführungsbeispiel mit 1010 insgesamt eine Leuchtelement-Einheit bezeichnet, welche ein Grundsubstrat 1012 umfaßt. Das Grundsubstrat 1012 kann aus einem gängigen, transparenten temperatur-und chemikalienbestandigen Glas gefertigt sein, wie es in der Technik häufig eingesetzt wird. Alternativ kann für das Grundsubstrat 1012 eine Keramik oder auch eine Metallplatte aus beispielsweise Kupfer oder Aluminium verwendet werden, Das Grundsubstrat hat in der Praxis eine Dicke von ca. 1 mm.

Auf das Grundsubstrat 1012 ist ein transparentes Substrat 1014 aus Korundglas (Al₂O₃-Glas) aufgebracht. Korundglas ist auch unter dem Namen Saphirglas bekannt. Das Substrat 1014 hat beim vorliegenden Ausführungsbeispiel eine Dicke von etwa 200 µm, es kann jedoch, wie eingangs erwähnt, auch andere Dicken haben, welche zwischen 5 und 400 µm liegen können.

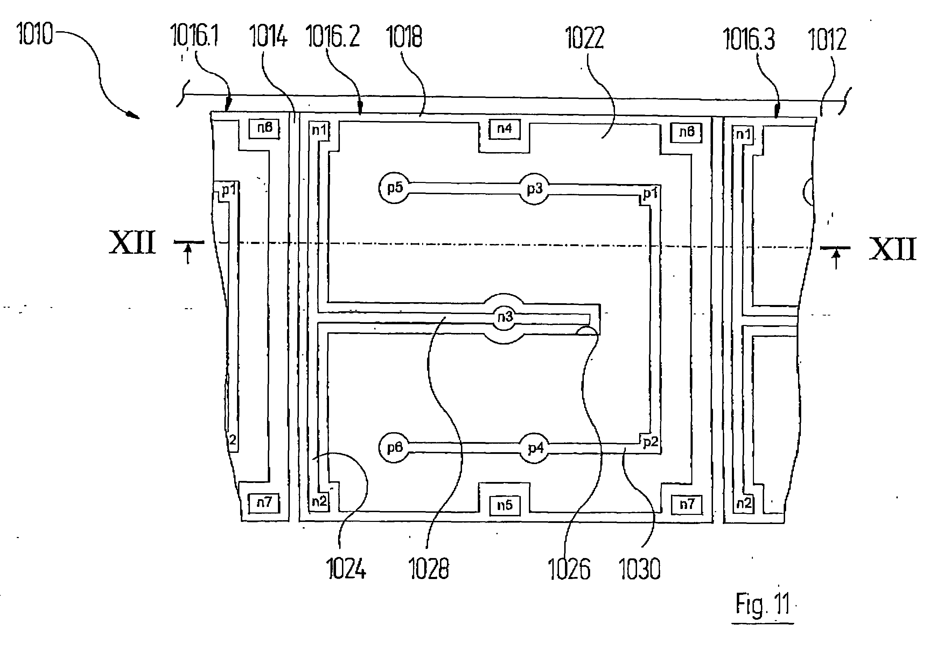

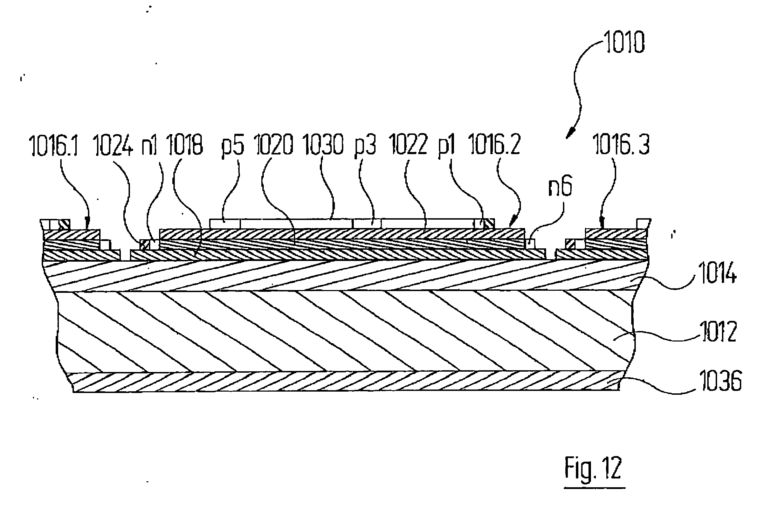

Das Substrat 1014 trägt seinerseits sechs voneinander beabstandet angeordnete Halbleiter-Leuchtelemente 1016.1, 1016.2, 1016.3, 1016.4, 1016.5 und 1016.6, welche weitgehend baugleich sind und nachstehend am Beispiel des Halbleiter-Leuchtelements 1016.2 anhand der Figuren 11 und 12 näher erläutert werden.

Das Halbleiter-Leuchtelement 1016.2 umfaßt drei Schichten. Eine untere Schicht 1018 ist aus einem p-leitenden III-V-Halbleitermaterial gefertigt, beispielsweise aus GaN. Eine mittlere Schicht 1020 ist eine MQW-Schicht. Eine obere Schicht 1022 ist ein n-leitende Schicht, welche z.B. aus InGaN besteht.

Das so aufgebaute Halbleiter-Leuchtelement 1016 - und somit die Leuchtelement-Einheit 1010 - strahlt bei Anlegen einer Spannung ultraviolettes Licht sowie blaues Licht in einem Wellenlängenbereich von 420 bis 480 nm ab. Eine Weißlicht-LED kann mit derartigen Halbleiter-Leuchtelementen 1016 dadurch erhalten werden, daß die Leuchtelement-Einheit 1010 in der LED von einem Silikonöl umgeben ist, in welchem Phosphorpartikel homogen verteilt sind. Geeignete Phosphorpartikel sind aus einem Farbzentren aufweisenden transparenten Festkörpermaterial hergestellt. Um das von den Halbleiter-Leuchtelementen 1016 emittierte ultraviolette und blaue Licht in Weißlicht umzuwandeln, werden drei Arten Phosphorpartikel verwendet, die das ultraviolette und blaue Licht absorbieren und im Blauen, Gelben und Roten emittieren.

Indem das Halbleiter-Leuchtelement 1016 aus Schichten 1018, 1020 und 1022 aufgebaut wird, die aus anderen Materialien ausgebildet sind, kann eine Halbleiter-Leuchtelement 1016 hergestellt werden, welche entsprechend den ausgewählten Materialien anderes Licht als ultraviolettes oder blaues Licht emittieren kann.

Die p-leitende Schicht 1018 ragt seitlich über die MQW-Schicht 1020 und die n-leitende Schicht 1022 hinaus. In einem Randbereich der p-leitenden Schicht ist neben der MQW-Schicht 1020 und der n-leitenden Schicht 1022 eine Leiterbahn 1024 aufgedampft, an deren jeweiligem Ende ein Anschlußkontakt n1 bzw. n2 vorgesehen ist.

Um die p-leitende Schicht 1018 auch mittig kontaktieren zu können, weisen die MQW-Schicht 1020 und die n-leitende Schicht 1022 eine gemeinsame schlitzförmige Ausnehmung 1026 auf. In dieser verläuft unter seitlichem Abstand eine Leiterbahn 1028, bei welcher mittig zum Halbleiter-Leuchtelement 1016 ein weiterer Anschlußkontakt n3 vorgesehen ist. Die Leiterbahn 1028 verläuft senkrecht zur Leiterbahn 1024 und ist mit dieser verbunden, so daß die Leiterbahnen 1024 und 1028 zusammen eine insgesamt T-förmige Leiterbahn mit den drei Anschlußkontakten n1, n2 und n3 bilden. Entlang der beiden zur Leiterbahn 1028 parallel verläufenden Ränder der p-leitenden Schicht 1018 sind noch jeweils zwei mit dieser verbundene Anschlußkontakte n4 und n6 bzw. n5 und n7 vorgesehen (vgl. Figur 11).

Auf die n-leitende Schicht 1022 ist eine U-förmige Leiterbahn 1030 aufgedampft, deren Grundschenkel der Leiterbahn 1024 auf der p-leitenden Schicht 1018 gegenüberliegt und deren beiden Seitenschenkel die Leiterbahn 1028 flankieren, wie dies insbesondere in Figur 11 zu erkennen ist.

Die Leiterbahn 1030 ist mit sechs Anschlußkontakten p1 bis p6 versehen, von denen jeweils drei auf einem Seitenschenkel der U-förmigen Leiterbahn 1030 angeordnet sind.

Die Leiterbahnen 1024, 1028 und 1030 sind durch Aufdampfen einer Kupfer-Gold-Legierung erhalten. Alternativ können auch Silber- oder Aluminium-Legierungen verwendet werden. Die Anschlußkontakte n1 bis n7 bzw. p1 bis p6 sind in üblicher Weise aus Gold hergestellt, welches in an und für sich bekannter Weise für den Anschluß an eine p-leitende Schicht bzw. eine n-leitende Schicht dotiert ist.

Bei der in Figur 10 vollständig zu erkennenden Leuchtelement-Einheit 1010 mit sechs Halbleiter-Leuchtelementen 1016 sind je drei Halbleiter-Leuchtelementen 1016.1, 1016.2 und 1016.3 sowie 1016.4, 1016.5 und 1016.6 zu je einem Satz elektrisch in Reihe geschaltet. Bei den außen liegenden Halbleiter-Leuchtelementen 1016.1 und 1016.4 eines Satzes sind die Leiterbahnen 1024 mit jeweils einer Anschlußplatte 1032 verbunden. In entsprechender Weise sind die Leiterbahnen 1030 der gegenüberliegend außenliegenden Halbleiter-Leuchtelementen 1016.3, 1016.6 eines Satzes aus drei in Reihe geschalteten Halbleiter-Leuchtelementen mit jeweils einer Anschlußplatte 1034 verbunden.

Die beiden Sätze aus drei in Reihe geschalteten Halbleiter-Leuchtelementen 1016 sind in Parallelschaltung zwischen den Anschlußplatten 1032 und 1034 geschaltet. Unter Betriebsbedingungen des Leuchtelements 1010 sind die Anschlußplatten 1032 und 1034 mit den Anschlußklemmen einer hier nicht eigens gezeigten Spannungsquelle verbunden.

Bei der Herstellung des oben beschriebenen Leuchtelements 1010 wird das Grundsubstrat 1012, beispielsweise eine Glasplatte mit einer Dicke von 1 mm, mit dem Substrat 1014 aus Saphirglas (Al₂O₃-Glas) beschichtet. Auf das Saphirglas 1014 wird wiederum ein GaN-Wafer aufgebracht. Mittels der an und für sich bekannten Verfahren der Fotolithografie und der Trockenätzung werden dann aus dem GaN-Material auf dem Substrat 1014 die Halbleiter-Leuchtelements 1016.1 bis 1016.6 aufgebaut und durch Aufdampfen der Leiterbahnen 1024, 1028 und 1030 vollendet.

Soweit es die Fläche des Grundsubstrats und des darauf aufgebrachten Substrats mit GaN-Material zuläßt, werden mehrere Halbleiter-Leuchtelementen 1016 verschiedener Leuchtelemente 1010 in einem Prozess erzeugt und die verschiedenen Leuchtelemente 1010 hiernach mittels bekannter Techniken aus dem Grundsubstrat 1012 herausgeschnitten.

Die Halbleiter-Leuchtelemente 1016.1 bis 1016.6 eines herausgeschnittenen Leuchtelements werden wie oben beschrieben in Reihe bzw. parallel geschaltet.

Die den Halbleiter-Leuchtelementen 1016 gegenüberliegende Seite des Grundsubstrats 1012 wird zusätzlich mit einer Verspiegelung 1036 versehen (vgl. Figur 12). Falls anstelle eines Glases eine Keramik oder ein Metall mit reflektierender Wirkung für das Grundsubstrat 1012 verwendet wird, kann auf die rückseitige Verspiegelung verzichtet.werden.

Wenn für das Grundsubstrat 1012 ein Glas verwendet wird, kommt insbesondere ein Bor-Tonerde-Glas in Frage. Derartige Gläser werden unter vielen Bezeichnungen vertrieben. Zusammenfassend kommen alle Gläser in Frage, welche eine ausreichende Widerstandsfähigkeit gegen äußere Einflüsse, wie Temperaturschwankungen und Chemikalien, aufweisen.

Jedes Halbleiter-Leuchtelement 1016 kann auch als Halbleiter-Chip bezeichnet werden. Ein derartiger einzelner Halbleiter-Chip hat beim hier beschriebenen Ausführungsbeispiel eine seitenlänge von 1500 µm. Somit hat ein einzelner Halbleiter-Chip 1016 eine Fläche von 1500 µm x 1500 µm. Ein einzelner Halbleiter-Chip hat dabei eine Aufnahmeleistung von 2,25 W. Bei einer Anordnung von sechs Halbleiter-Chips 1016 in der gezeigten 2x3-Matrix ergeben sich somit insgesamt 13,5 W Aufnahmeleistung.

Wird ein einzelner Halbleiter-Chip 1016 mit einer Fläche von 1800 µm x 1800 µm aufgebaut, so ergibt sich hieraus eine Aufnahmeleistung von 3,24 W. Daraus resultiert bei 2x3 Halbleiter-Chips 1116 eine Gesamtaufnahmeleistung von 19,44 W. Bei letzterem Aufbau wird eine Lichtleistung von etwa 1555 Lumen erreicht.

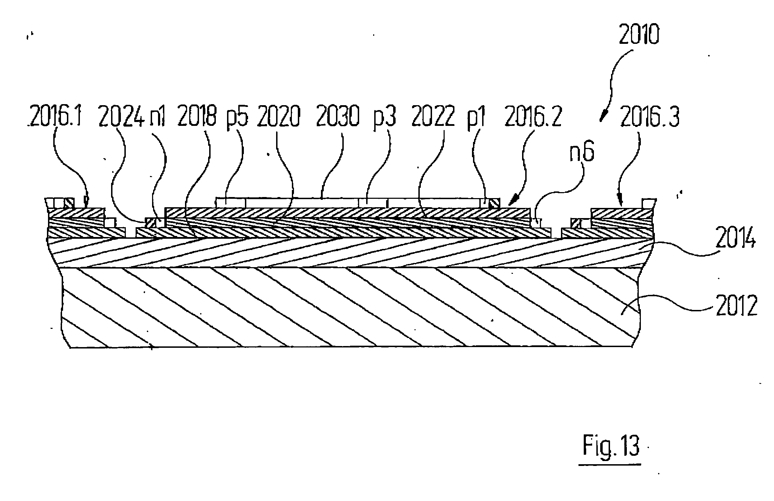

Eine Abwandlung der Leuchtelement-Einheit 1010 nach den Figuren 10 bis 12 ist in Figur 13 anhand eines Leutelement-Einheit 2010 gezeigt. Den Figuren 10 bis 12 entsprechende Komponenten tragen in Figur 13 dieselben Bezugszeichen zuzüglich 1000. Das oben zur Leuchtelement-Einheit 1010 Gesagte gilt sinngemäß entsprechend auch für die Leuchtelement-Einheit 2010.

Im Unterschied zu der in den Figuren 10 bis 12 gezeigten Leuchtelement-Einheit 1010 ist bei der Leuchtelement-Einheit 2010 keine Verspiegelung vorgesehen.

Da keine Verspiegelung vorgesehen ist, wird von jedem Halbleiter-Leuchtelement 2016 Licht in weitgehend alle Raumrichtungen abgestrahlt. Mit jedem Halbleiter-Leuchtelement 2016 bzw. mit der Leuchtelement-Einheit 2016 kann die von einem Betrachter zu erkennende Leuchtwirkung einer Glühbirne nachgeahmt werden. Dazu kann die Leuchtelement-Einheit 2010 im Betrieb beispielsweise in einem entsprechenden Gehäuse untergebracht sein, aus dem Licht in alle Raumrichtungem austreten kann.

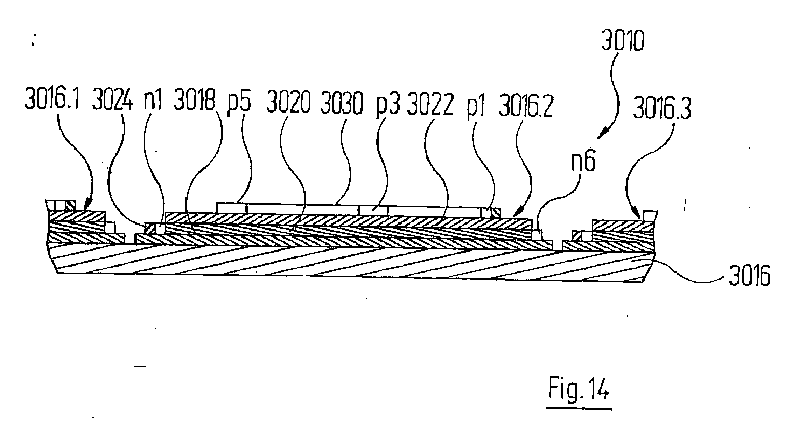

Eine weitere Abwandlung der Leuchtelement-Einheit 1010 nach den Figuren 10 bis 12 ist in Figur 14 anhand einer Leutelement-Einheit 3010 gezeigt. Den Figuren 10 bis 12 entsprechende Komponenten tragen in Figur 14 dieselben Bezugszeichen zuzüglich 2000.

Das oben zu der Leuchtelement-Einheit 1010 Gesagte gilt sinngemäß entsprechend auch für die Leuchtelement-Einheit 3010.

Die Leuchtelement-Einheit 3010 mit den Halbleiter-Leuchtelementen 3016 weist weder eine Verspiegelung noch ein Grundsubstrat auf. Die Leuchtelement-Einheit 3010 entspricht dem in Figur 5 gezeigten Leuchtmittel 10. D.h. ein Halbleiterelement 3016 ist von einem Substrat 3014 getragen, welches aus den oben zum Trägersubstrat 14 des Ausführungsbeispiels der Figuren 10 bis 12 genannten Materialen, insbesondere aus Saphirglas (Al₂O₃-Glas), gefertigt ist.

Auch mit der Leuchtelement-Einheit 3010 bzw. mit den Halbleiter-Leuchtelementen 3016 kann die von einem Betrachter zu erkennende Leuchtwirkung einer Glühbirne nachgeahmt werden.

## Patentansprüche

1. Halbleiter-Leuchtmittel mit mindestens einem bei Spannungsbeaufschlagung leuchtenden Halbleiter-Leuchtelement (26, 28, 1016, 2016, 3016) und einem dieses tragenden Substrat (12, 1014, 2014, 3014), **dadurch gekennzeichnet, daß** das Substrat (12, 1014, 2014, 3014) für das von den Halbleiter-Leuchtelementen (26, 28, 1016, 2016, 3016) erzeugte Licht durchlässig ist.

2. Leuchtmittel nach Anspruch 1, **dadurch gekennzeichnet, daß** das substrat (12, 1014, 2014, 3014) ein Glasmaterial oder ein Kristallmaterial umfasst.

3. Leuchtmittel nach Anspruch 2, **dadurch gekennzeichnet, daß** das Glasmaterial oder das Kristallmaterial ein Al₂O₃-Material ist.

4. Leuchtmittel nach einem der Ansprüche 1 bis 3, **dadurch gekennzeichnet, daß** das Substrat (12, 1014, 2014, 3014) eine Dicke von etwa 0,1 mm bis etwa 1 mm, vorzugsweise von etwa 0,1 mm bis etwa 0,5 mm, nochmals vorzugsweise von etwa 0,2 mm bis etwa 0,4 mm aufweist.

5. Leuchtmittel nach einem der Ansprüche 1 bis 4, **dadurch gekennzeichnet, daß** mindestens ein Halbleiter-Leuchtelement (26, 28, 1016, 2016, 3016) eine Dreischicht-struktur ist, wobei die erste Schicht (30, 1018, 2018, 3018) eine Halbleiterschicht, die zweite Schicht (32, . 1020, 2020, 3020) eine MQW-Schicht und die dritte Schicht (34, 1022, 2022, 3022) eine Halbleiterschicht ist.

6. Leuchtmittel nach Anspruch 5, **dadurch gekennzeichnet, daß** mindestens eine der Halbleiterschichten ein III-V-Material umfasst.

7. Leuchtmittel nach Anspruch 6, **dadurch gekennzeichnet, daß** eine der Halbleiterschichten durch GaN gebildet ist.

8. Leuchtmittel nach Anspruch 6 oder 7, **dadurch gekennzeichnet, daß** eine der Halbleiterschichten durch InGaN gebildet ist.

9. Leuchtmittel nach einem der Ansprüche 1 bis 8, **dadurch gekennzeichnet, daß** die Halbleiter-Leuchtelemente (26, 28) transparent sind.

10. Leuchtmittel nach einem der Ansprüche 1 bis 9, **dadurch gekennzeichnet, daß** eine Mehrzahl von Halbleiter-Leuchtelementen (26, 28) durch verschachtelte Elektroden (14, 36) kontaktiert sind.

11. Leuchtelement nach einem der Ansprüch 1 bis 10,
**dadurch gekennzeichnet, daß** das Substrat (12) auf beiden Seiten Halbleiter-Leuchtelemente (26, 28) trägt.

12. Leuchtmittel nach Anspruch 11, **dadurch gekennzeichnet, daß** die auf den beiden Seiten des Substrates (12) angeordneten Sätze von Halbleiter-Leuchtelementen (26, 28) gegeneinander versetzt sind.

13. Leuchtmittel nach einem der Ansprüche 1 bis 12,
**gekennzeichnet durch** ein für das von den Halbleiter-Leuchtelementen (26, 28) erzeugte Licht durchlässiges Gehäuse (56), von welchem das Substrat (12) getragen ist.

14. Leuchtmittel nach Anspruch 13, **dadurch gekennzeichnet, daß** das Gehäuse (56) eine Mehrzahl von Substraten (12) umschließt.

15. Leuchtmittel nach Anspruch 13 oder 14, **dadurch gekennzeichnet, daß** das Innere des Gehäuses (56) eine transparente Flüssigkeit enthält.

16. Leuchtmittel nach Anspruch 15, **dadurch gekennzeichnet, daß** die transparente Flüssigkeit ein silikonöl ist.

17. Leuchtmittel nach einem der Ansprüche 13 bis 16,
**dadurch gekennzeichnet, daß** das Gehäuse (56) mindestens eine gewölbte Begrenzungsfläche aufweist, insbesondere rotationssymmetrisch ist.

18. Leuchtmittel nach einem der Ansprüche 13 bis 17,
**dadurch gekennzeichnet, daß** die Halbleiter-Leuchtelemente (26, 28) im UV oder im Blauen strahlen und im Inneren des Gehäuses Phosphorpartikel verteilt sind, die im Blauen, Gelben und Roten emittieren, derart, daß das Leuchtmittel weißes Licht abgibt.

19. Leuchtmittel nach Anspruch 18, **dadurch gekennzeichnet, daß** die Phosphorpartikel auf das Substrat (12) und/oder die Halbleiter-Leuchtelemente (26, 28) und/oder die Innen- oder Außenfläche des Gehäuses (56) aufgebracht sind.

20. Leuchtmittel nach Anspruch 18 oder 19, **dadurch gekennzeichnet, daß** die Phosphorpartikel in einer Flüssigkeit (54) oder einem festen transparenten Einbettungsmaterial verteilt sind, die/das das die Halbleiter-Leuchtelemente (26, 28) tragende Substrat (12) umgibt.

21. Leuchtmittel nach einem der Ansprüche 1 bis 20,
**dadurch gekennzeichnet, daß** das Halbleiter-Leuchtelement (26, 28) ausgedehnte Kontaktleiterbahnen (14, 36) trägt.

22. Leuchtmittel nach Anspruch 21, **dadurch gekennzeichnet, daß** die beiden Kontaktleiterbahnen (14, 36) so angeordnet sind, daß jeweils einander gegenüberliegende Abschnitte (16, 22, 24, 44, 46) beider Kontaktleiterbahnen (14, 36) im wesentlichen gleichen Abstand voneinander haben.

23. Leuchtmittel nach Anspruch 22, **dadurch gekennzeichnet, daß** die Abschnitte (16, 22, 24, 44, 46) der Kontaktleiterbahnen (16, 36) kammähnlich ineinander greifen.

24. Leuchtmittel nach einem der Ansprüche 21 bis 23,
**dadurch gekennzeichnet, daß** die Kontaktleiterbahnen (16, 36) jeweils über eine Mehrzahl von elektrischen Verbindungsstellen (n1 bis n7, p1 bis p6) mit Speiseleiterbahnen (86, 88) eines Basissubstrates (84) verbunden sind.

25. Leuchtmittel nach Anspruch 24, **dadurch gekennzeichnet, daß** das Basissubstrat (84) ein Glasmaterial oder ein Kristallmaterial umfasst.

26. Leuchtmittel nach Anspruch 25, **dadurch gekennzeichnet, daß** das Glasmaterial oder das Kristallmaterial ein Al₂O₃ Material ist.

27. Leuchtmittel nach einem der Ansprüche 24 bis 26,
**dadurch gekennzeichnet, daß** das Basissubstrat (84) eine Dicke von etwa 0,2 mm bis etwa 2 mm, vorzugsweise von etwa 0,2 mm bis etwa 1,0 mm, nochmals vorzugsweise von etwa 0,4 mm bis etwa 0,6 mm aufweist.

28. Leuchtmittel nach einem der Ansprüche 24 bis 27,
**dadurch gekennzeichnet, daß** das Basissubstrat (84) eine reflektierende Oberfläche aufweist.

29. Leuchtmittel nach Anspruch 28, **dadurch gekennzeichnet, daß** das Basissubstrat (84) aus einem isolierenden reflektierenden Material besteht oder mit einem solchen beschichtet ist.

30. Leuchtmittel nach Anspruch 29, **dadurch gekennzeichnet, daß** das isolierende reflektierende Material ein Oxidmaterial, insbesondere ein Keramikmaterial ist.

31. Leuchtmittel nach einem der Ansprüche 1 bis 30,
**dadurch gekennzeichnet, daß** hinter dem HalbleiterElement (26, 28) ein Reflektorteil (98) angeordnet ist.

32. Leuchtmittel nach Anspruch 31, **dadurch gekennzeichnet, daß** das Reflektorteil (98) aus einem Kristallmaterial hergestellt ist, welches vorzugsweise auf der Rückseite verspiegelt ist.

33. Leuchtmittel nach einem der Ansprüche 13 bis 32,
**dadurch gekennzeichnet, daß** die Halbleiter-Leuchtelemente (26, 28) unter Verwendung eines transparenten Harzes, vorzugsweise Epoxidharz in das lichtdurchlässige Gehäuse (56) eingegossen sind.

34. Leuchtmittel nach einem der Ansprüche 13 bis 33,
**dadurch gekennzeichnet, daß** die Innenseite des Gehäuses (56) eine lichtdurchlässige Elektrode (114) trägt. und das Gehäuse (54) auf niederen Druck evakuiert ist.

35. Leuchtmittel nach Anspruch 34, **dadurch gekennzeichnet, daß** die Elektrode (114) als Gitter ausgebildet ist.

36. Leuchtmittel nach Anspruch 35, **dadurch gekennzeichnet, daß** die Elektrode (114) aus Graphit hergestellt ist.

37. Leuchtmittel nach einem der Ansprüche 34 bis 36,
**dadurch gekennzeichnet, daß** die Elektrode (114) mit Phosphormaterial (112) überschichtet ist.

38. Leuchtmittel nach einem der Ansprüche 34 bis 37,
**dadurch gekennzeichnet, daß** die Elektrode (114) mit einer Anschlußklemme (116) in Verbindung steht, die mit einer Hochspannungsquelle (118) verbindbar ist.

39. Leuchtmittel nach einem'der Ansprüche 1 bis 38,
**dadurch gekennzeichnet, daß** das Substrat (1014, 2014, 3014) seinerseits von einem Grundsubstrat (1012, 2012, 3012) getragen ist.

40. Leuchtmittel nach Anspruch 39, **dadurch gekennzeichnet, daß** das Grundsubstrat (1012, 2012, 3012) ein Glasmaterial, insbesondere ein Bor-Tonerde-Glas, umfaßt.

41. Leuchtmittel nach Anspruch 40, **dadurch gekennzeichnet, daß** die Zusammensetzung des Glasmaterials des Grundsubstrats (1012, 2012, 3012) etwa einer der folgenden entspricht:
a) 81% SiO₂, 13% B₂O₃, 4% Alkali, 2% Al₂O₃; oder
b) 57% SiO₂, 1% Na₂O, 12% MgO, 26% Al₂O₃, 4% B₂O₃.

42. Leuchtmittel nach Anspruch 39, **dadurch gekennzeichnet, daß** das Grundsubstrat (1012, 2012, 3012) ein Keramikmaterial umfaßt.

43. Leuchtmittel nach Anspruch 39, **dadurch gekennzeichnet, daß** das Grundsubstrat (1012, 2012, 3012) ein Metall, insbesondere Kupfer oder Aluminium, umfaßt.

44. Leuchtmittel nach einem der Ansprüche 39 bis 43,
**dadurch gekennzeichnet, daß** das Substrat (1014) und das Grundsubstrat (1012) zumindest teilweise für die von dem Halbleiter-Leuchtelement (1016) emittierte Strahlung transparent sind und die dem Substrat (1014) gegenüberliegende Seite des Grundsubstrats (1012) mit einer diese Strahlung in Richtung auf das Substrat (1014) reflektierenden Schicht (1036) versehen ist.

45. Leuchtmittel nach einem der Ansprüche 39 bis 44,
**dadurch gekennzeichnet, daß** das Grundsubstrat (1012, 2012, 3012) eine Dicke von 0,5 mm bis 2,0 mm, bevorzugt von 0,75 mm bis 1,5 mm und nochmals bevorzugt von etwa 1,0 mm hat.

46. Leuchtmittel nach einem der Ansprüche 39 bis 45,
**dadurch gekennzeichnet, daß** das Substrat (1014, 2014, 3014) eine Dicke von 5 µm bis 400 µm, bevorzugt von 5 µm bis 200 µm, nochmals bevorzugt von 10 µm bis 100 µm und nochmals bevorzugt von 50 µm bis 75 µm hat.

47. Leuchtpaneel, gekennzeichent durch eine Vielzahl von Leuchmitteln nach einem der Ansprüche 1 bis 46, welche in einem planparallele Deckplatten (74, 76) aufweisenden Paneelgehäuse (70) angeordnet sind.

48. Leuchtpaneel nach Anspruch 47, **dadurch gekennzeichnet,**
**daß** der zwischen den Leuchtmitteln (56) und dem Paneelgehäuse liegende Raum durch eine transparente Kühlflüssigkeit, insbesondere ein Silikonöl gefüllt ist.

49. Leuchtpaneel nach Anspruch 47 oder 48, **dadurch gekennzeichnet, daß** im Inneren des Paneelgehäuses (70) Phosphorpartikel verteilt sind, die im Blauen, Gelben und Roten emittieren, derart, daß das Leuchtpaneel weißes Licht abgibt.

50. Leuchtpaneel nach Anspruch 49, **dadurch gekennzeichnet, daß** die Phosphorpartikel auf die Leuchtmittel (56) und/oder die Innen- oder Außenfläche des Paneelgehäuses (70) aufgebracht sind.

51. Leuchtpaneel nach Anspruch 49 oder 50, **dadurch gekennzeichnet, daß** die Phosphorpartikel in einer Flüssigkeit (80) verteilt sind, die die Leuchtmittel (56) umgibt.

52. Leuchtpaneel nach der Ansprüche 47 bis 51, **dadurch** ge**gekennzeichnet**, daß eine (74) der Deckplatten (74, 76) verspiegelt (78) ist.

53. Leuchtpaneel nach der Ansprüche 47 bis 52, **dadurch** ge**gekennzeichnet**, daß eine (74) der Deckplatten (74, 76) als Mattscheibe (82) ausgebildet ist.
